Europäisches Patentamt

European Patent Office

Office européen des brevets

(11) Veröffentlichungsnummer: **0 490 303 A2**

# EUROPÄISCHE PATENTANMELDUNG

(21) Anmeldenummer: **91121012.8**

(22) Anmeldetag: **07.12.91**

(51) Int. Cl.$^5$: **G01R 35/00**

(30) Priorität: **12.12.90 DE 4039594**

(43) Veröffentlichungstag der Anmeldung:
**17.06.92 Patentblatt 92/25**

(84) Benannte Vertragsstaaten:
**AT BE CH DE DK ES FR GB GR IT LI LU NL SE**

(71) Anmelder: **THEO BENNING ELEKTROTECHNIK
UND ELEKTRONIK GMBH & CO. KG
Münsterstrasse 135 - 137 Postfach 63
W-4290 Bocholt(DE)**

(72) Erfinder: **Steinig, Walter
Up de Dohre 15
W-4290 Bocholt(DE)**
Erfinder: **Wessels, Josef
Winterswijker Strasse 2
W-4290 Bocholt-Stenern(DE)**

(74) Vertreter: **Patentanwälte Dipl.-Ing. Alex
Stenger Dipl.-Ing. Wolfram Watzke Dipl.-Ing.
Heinz J. Ring
Kaiser-Friedrich-Ring 70
W-4000 Düsseldorf 11(DE)**

(54) Verfahren zum Eichen der Spannungsschwellen bei einem Spannungsprüfer zur stufenweisen insbesondere optischen Anzeige einer Spannung.

(57) Ein Verfahren zum Eichen der Spannungsschwellen bei einem Spannungsprüfer zur stufenweisen insbesondere optischen Anzeige einer Spannung, wobei in Reihe geschalteten Widerständen für die einzelnen Stufen jeweils eine Anzeigeeinrichtung, insbesondere eine Leuchtdiode zugeordnet ist, sieht vor, daß an den Widerständen jeweils nach Anlegen eines Stromes die Spannung abgegriffen und kontinuierlich gemessen und dabei der elektrische Widerstand so lange verändert wird, bis der vorgegebene Spannungswert für die jeweilige Spannungsschwelle erreicht wird. Vorzugsweise ist dabei das Widerstandsmaterial der Widerstände flächig auf einer Platine aufgedruckt und wird zur Verlängerung des Stromlaufweges mittels eines Laserstrahls linienförmig verdampft.

EP 0 490 303 A2

Die Erfindung betrifft ein Verfahren zum Eichen der Spannungsschwellen bei einem Spannungsprüfer zur stufenweisen insbesondere optischen Anzeige einer Spannung, wobei in Reihe geschalteten Widerständen für die einzelnen Stufen jeweils eine Anzeigeeinrichtung, insbesondere eine Leuchtdiode zugeordnet ist.

Spannungsprüfer zur stufenweisen optischen Anzeige einer Spannung, bei denen je nach gemessenem Spannungsbereich eine Leuchtdiode aufleuchtet, sind bekannt. Derartige Spannungsmesser weisen in Reihe geschaltete Widerstände auf, wobei jedem dieser Widerstände eine Spannungsstufe zugeordnet ist. Jedem dieser Widerstände ist hinwiederum eine optische Anzeige insbesondere in Form einer Leuchtdiode zugeordnet, wobei die Leuchtdiode einer bestimmten Stufe dann aufleuchtet, wenn die ihr zugeordnete Spannungsschwelle überschritten worden ist.

Ein Nachteil bei diesen bekannten Spannungsprüfern ist, daß die die Spannungsschwellen definierenden Widerstände hinsichtlich ihres elektrischen Widerstandswertes nicht exakt sind. Dies bedeutet in der Praxis, daß eine falsche Spannung bzw. ein falscher Spannungsbereich angezeigt wird.

Davon ausgehend liegt der Erfindung die **Aufgabe** zugrunde, ein Verfahren zum Eichen der Spannungsschwellen bei einem Spannungsprüfer zur stufenweisen insbesondere optischen Anzeige einer Spannung zu schaffen.

Als technische **Lösung** wird mit der Erfindung vorgeschlagen, daß an den Widerständen jeweils nach Anlegen eines Stromes die Spannung abgegriffen und kontinuierlich gemessen und dabei der elektrische Widerstand so lange verändert wird, bis der vorgegebene Spannungswert für die jeweilige Spannungsschwelle erreicht wird.

Ein derartiges Verfahren zum Eichen der Spannungsschwellen bei einem Spannungsprüfer zur stufenweisen optischen Anzeige einer Spannung hat den Vorteil, daß die angezeigten Spannungswerte bzw. Spannungsbereiche exakt sind, da die die Spannungsschwellen bestimmenden Widerstände exakt hinsichtlich ihres elektrischen Widerstandswertes eingestellt sind. Durch das erfindungsgemäße Verfahren zum Festlegen der Spannungsschwellen werden somit falsche Meßergebnisse durch den Spannungsprüfer vermieden.

In einer vorteilhaften Weiterbildung des erfindungsgemäßen Verfahrens wird vorgeschlagen, daß der elektrische Widerstand erhöht wird, so daß während des Eichverfahrens bei konstant anliegenden Strom der Spannungswert kontinuierlich erhöht und von unten her der jeweiligen Spannungsschwelle angenähert wird.

In einer bevorzugten Weiterbildung des erfindungsgemäßen Verfahrens wird vorgeschlagen, daß das Widerstandsmaterial der Widerstände jeweils flächig ausgebildet ist und derart für die Veränderung des elektrischen Widerstandes geprägt wird, daß die wirksame Länge für den Stromlauf und damit der elektrische Widerstand erhöht wird. Unter "prägen" des Widerstandsmaterials wird dabei verstanden, daß der elektrische Stromfluß im Prägebereich unterbrochen ist, so daß der elektrische Strom unter Umgehung des Prägebereiches einen Umweg gehen muß, was die effektive Länge des Widerstandsmaterials im Hinblick auf die Stromlauflänge vergrößert. Man macht sich dabei den physikalischen Umstand zunutze, daß bei länger werdendem Widerstand und dabei bei länger werdendem Stromlauf der elektrische Widerstandswert entsprechend erhöht wird. Die sukzessive Erhöhung des elektrischen Widerstandes läßt sich somit dadurch realisieren, daß das flächige Widerstandsmaterial sukzessive geprägt wird, bis der vorgegebene Widerstandswert und somit der vorgegebene Spannungswert zum Erreichen der jeweiligen Spannungsschwelle erhöht wird. Sobald der vorgegebene Spannungswert erreicht ist, wird mit dem Prägen aufgehört.

In einer vorteilhaften Weiterbildung ist das Widerstandsmaterial auf eine Platine oder dgl. aufgebracht, insbesondere aufgedruckt. Dies stellt eine technisch einfache Möglichkeit dar, um das Widerstandsmaterial prägen zu können.

In einer weiteren Weiterbildung des Prägevorganges wird vorgeschlagen, daß das Widerstandsmaterial über die Länge des Widerstandes derart mit querverlaufenden Prägungen versehen wird, daß der Stromlauf im wesentlichen zickzackförmig erfolgt. Die querverlaufenden Prägelinien beginnen dabei jeweils abwechselnd am rechten und am linken Rand des Widerstandsmaterials, reichen aber nicht ganz bis zum jeweiligen gegenüberliegenden Rand, so daß hier die Umkehrung des Stromlaufes um 180° erfolgt.

Schließlich wird in einer bevorzugten Durchführung des Prägevorganges vorgeschlagen, daß ein Laserstrahl über die Oberfläche des Widerstandsmaterials geführt wird. Der Laserstrahl verdampft dabei das Widerstandsmaterial an der Auftreffstelle und schafft somit eine (elektrische) Unterbrechung und damit Prägung. Der Laserstrahl hat dabei den Vorteil, daß er sehr gebündelt ist und daher ein sehr feines und exaktes Prägemuster auf das Widerstandsmaterial aufgebracht werden kann. Sobald der vorgegebene Spannungswert erreicht ist, wird der Laserstrahl unterbrochen.

Das erfindungsgemäße Vefahren zum Eichen der Spannungsschwellen bei einem Spannungsprüfer zur stufenweise optischen Anzeige einer Spannung wird nachfolgend anhand der Zeichnungen beschrieben, in denen eine Vorrichtung zur Durchführung des Eichverfahrens dargestellt ist. In den Zeichnungen zeigt:

Fig. 1    eine erste Schaltung eines Spannungsprüfers;

Fig. 2    eine zweite Schaltung eines Spannungsprüfers;

Fig. 3    in einer rein schmatischen, perspektivischen Darstellung das Prägen des auf eine Platine aufgedruckten Widerstandsmaterials mittels eines Laserstrahles.

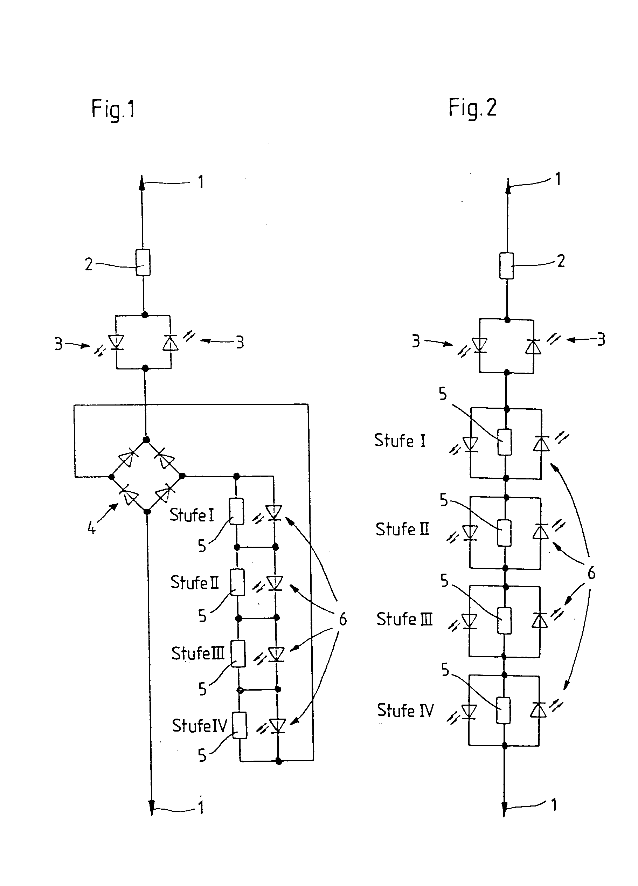

In Fig. 1 ist eine erste Schaltung für einen Spannungsprüfer zur stufenweisen optischen Anzeige einer Spannung an zwei Prüfspitzen 1 dargestellt. Die Schaltungsanordnung besteht dabei aus einem in Reihe geschalteten Vorwiderstand 2, zwei antiparallelen Leuchtdioden 3 einer Grundstufe sowie aus einem Gleichrichter 4, der ebenfalls als Grundstufe dient.

An diese Grundstufe ist ein Gleichstromkreis gekoppelt, welcher vier Spannungsstufen aufweist. Diese Spannungsanzeigestufen (Schwellwertstufen) bestehen jeweils aus einem Widerstand 5 mit einer parallel geschalteten Leuchtdiode 6, wobei die Widerstände 4 in Reihe miteinander geschaltet sind.

Die Schaltung in Fig. 2 eines Spannungsprüfers zur stufenweisen Anzeige einer Spannung an zwei Prüfspitzen 1 weist ebenfalls in Reihe geschaltet einen Vorwiderstand 2, zwei antiparallele Leuchtdioden 2 als Grundstufe sowie vier Spannungsanzeigestufen auf. Diese Spannungsanzeigestufen bestehen aus in Reihe geschalteten Widerständen 5 mit jeweils zwei antiparallelen Leuchtdioden 6.

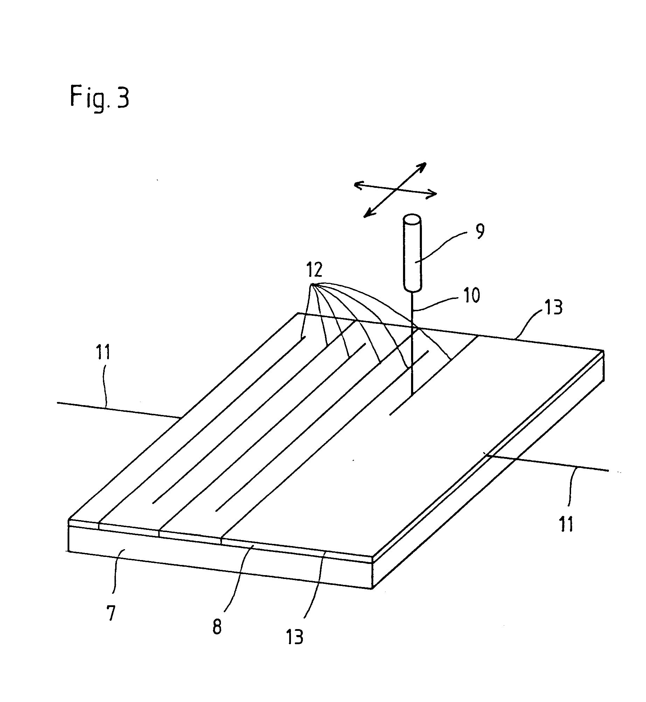

In den beiden Schaltungen in Fig. 1 und 2 sind die Widerstände 5 nur symbolisch angedeutet. Diese sind aber zur Festlegung der exakten Spannungsschwellen speziell geeicht. Zu diesem Zweck ist in Fig. 3 ein einziger derartiger Widerstand 5 dargestellt. Er besteht aus einer Platine 7, auf die entsprechendes Widerstandsmaterial 8 aufgebracht, insbesondere aufgedruckt ist.

Oberhalb des Widerstandes 5 ist ein Laser 9 zu erkennen, dessen Laserstrahl 10 nach unten auf das Widerstandsmaterial 8 gerichtet ist. Durch das Pfeilkreuz oberhalb des Lasers 9 ist angedeutet, daß dieser mittels eines entsprechenden, nicht dargestellten Mechanismus in horizontaler Richtung verschiebbar ist. An der Stelle, wo der Laserstrahl 10 auf das Widerstandsmaterial 8 auftrifft, wird dieses verdampft, so daß an dieser Stelle der elektrische Widerstandswert sehr groß wird und somit der Stromfluß an dieser Stelle unterbrochen ist.

Das erfindungsgemäße Verfahren zum Eichen des Widerstandes 5 funktioniert wie folgt:

An den Widerstand 5 wird ein elektrischer Strom eines ganz bestimmten Wertes angelegt. Dies ist durch die endseitigen Anschlüsse 11 an das Widerstandsmaterial 8 des Widerstandes 5 angedeutet. Gleichzeitig wird die am Widerstand 5 anliegende Spannung mittels eines entsprechenden Spannungsmessers abgegriffen und kontinuierlich gemessen. Dieser Spannungswert hängt von dem elektrischen Widerstand des Widerstandsmaterials 8 ab. Da im Ursprungszustand das Widerstandsmaterial 8 gleichmäßig auf der Platine 7 aufgetragen ist, besitzt der elektrische Widerstand einen Minimalwert. Durch Vergrößerung der Weglänge für den Stromlauf wird der elektrische Widerstandswert sukzessive erhöht. Zu diesem Zweck werden mittels des Laserstrahls 10 Linien 12 aus dem Widerstandsmaterial 8 derart verdampft, daß der Stromverlauf zickzackförmig erfolgt. Die Linien beginnen dabei abwechselnd an den beiden Längsrändern 13 des Widerstandsmaterials 8, reichen aber jeweils nicht ganz bis zum gegenüberliegenden Rand, so daß auf diese Weise der zickzackförmige Stromverlauf geschaffen wird. Da während des Verdampfens des Widerstandsmaterials 8 durch den Laserstrahl 10 die Spannung kontinuierlich gemessen wird, wird bei Erreichen des vorgegebenen Spannungswertes und damit bei Erreichen des zugehörigen, exakten Widerstandswertes der Laserstrahl 10 unterbrochen, da der jeweilige Widerstand 5 richtig geeicht ist.

## Bezugszeichenliste

1    Prüfspitze
2    Vorwiderstand
3    Leuchtdiode
4    Gleichrichter
5    Widerstand
6    Leuchtdiode
7    Platine
8    Widerstandsmaterial
9    Laser
10   Laserstrahl
11   Anschluß
12   Linie
13   Längsrand

## Patentansprüche

1.  Verfahren zum Eichen der Spannungsschwellen bei einem Spannungsprüfer zur stufenweisen insbesondere optischen Anzeige einer Spannung,
    wobei in Reihe geschalteten Widerständen für die einzelnen Stufen jeweils eine Anzeigeeinrichtung, insbesondere eine Leuchtdiode zugeordnet ist,
    **dadurch gekennzeichnet,**
    daß an den Widerständen jeweils nach Anlegen eines Stromes die Spannung abgegriffen und kontinuierlich gemessen und dabei der elektrische Widerstand so lange verändert wird, bis der vorgegebene Spannungswert für die jeweilige Spannungsschwelle erreicht wird.

2. Verfahren nach Anspruch 1, dadurch gekennzeichnet, daß der elektrische Widerstand erhöht wird.

3. Verfahren nach Anspruch 1 oder 2, dadurch gekennzeichnet, daß das Widerstandsmaterial der Widerstände jeweils flächig ausgebildet ist und derart für die Veränderung des elektrischen Widerstandes geprägt wird, daß die wirksame Länge für den Stromlauf und damit der elektrische Widerstand erhöht wird.

4. Verfahren nach Anspruch 3, dadurch gekennzeichnet, daß das Widerstandsmaterial auf einer Platine oder dgl. aufgebracht, insbesondere aufgedruckt ist.

5. Verfahren nach Anspruch 3 oder 4, dadurch gekennzeichnet, daß das Widerstandsmaterial über die Länge des Widerstandes derart mit querverlaufenden Prägungen versehen wird, daß der Stromlauf im wesentlichen zickzackförmig erfolgt.

6. Verfahren nach einem der Ansprüche 3 bis 5, dadurch gekennzeichnet, daß zum Prägen ein Laserstrahl über die Oberfläche des Widerstandsmaterials geführt wird.

7. Verfahren nach einem der Ansprüche 1 bis 6, dadurch gekennzeichnet, daß Abgriff, kontinuierliche Messung der Spannung und Veränderung des elektrischen Widerstandes an Widerständen erfolgen, die parallel zu der jeweils zugehörigen Anzeigeeinrichtung geschaltet sind.

Fig.1

Fig.2

Stufe I

Stufe II

Stufe III

Stufe IV

Stufe I

Stufe II

Stufe III

Stufe IV

Fig. 3